# EUROPÄISCHE PATENTANMELDUNG

(11) **EP 1 507 448 A1**
(43) Veröffentlichungstag der Anmeldung: **16.02.2005**
(21) Anmeldenummer: 03405588.9
(22) Anmeldetag: 12.08.2003
(51) Int. Cl.: H05K 3/46, H05K 3/44

(54) **Basismaterial, Substrat und Verbindungselement**

(71) Anmelder: Elmicron AG, 6304 Zug (CH)
(72) Erfinder: Schmidt, Walter, 8332 Russikon (CH); Steiert, Philippe, 6404 Greppen (CH)
(74) Vertreter: Walser, Peter

(57) **Zusammenfassung**

Das Basismaterial (101) für elektrische Verbindungselemente, also Leiterplatten, HDIs, Chip Carriers etc. besitzt als Kern eine mit Löchern (104) versehene elektrisch leitende Folie (102), beispielsweise aus Kupfer. Die Folie ist ein Dielektrikum (103) eingebettet. Die Löchern (104) können in einem regelmässigen Raster angeordnet sein. Durch die verstärkende elektrisch leitende Schicht besitzt das Basismaterial hervorragende mechanisch Eigenschaften. Die leitende Schicht wirkt überdies abschirmend, kann also bei kleinen Schichtdicken cross-talk zwischen beidseitig des Basismaterials angebrachten Leiterbahnen verhindern.

## Beschreibung

Die Erfindung betrifft ein Basismaterial für elektrische Verbindungselemente wie Leiterplatten, Chipcarriers, HDIs, Interposers etc. Sie betrifft auch ein aus solchem Basismaterial hergestelltes Substrat sowie ein elektrisches Verbindungselement, welches dieses Basismaterial aufweist.

Für elektronische Schaltungsträger wie Leiterplatten oder Chipcarriers werden heute zunehmend Herstellungstechnologien verwendet, die die Herstellung feinster Leiterstrukturen sowohl in x/y als auch in z-Richtung gestatten. Die Leiterabmessungen liegen heute bei ca. 75 µm mit einem klaren Trend zu noch feineren Strukturen im Bereich von 25 µm und darunter. Die in z-Richtung verlaufenden Leiter werden heute durch feinste Bohrungen bewerkstelligt, die durch bekannte Verfahren der elektrischen Durchkontaktierung mittels Kupfer belegt werden und dadurch die elektrischen Signale bzw. die Energiezufuhr zu den aktiven und passiven elektronischen Komponenten bewerkstelligen können.

Diese Mikrolöcher (microvia) können durch verschiedene Verfahren hergestellt werden, wie z. B. mechanisches Mikrobohren, Laserbohren, Plasmaätzen und andere.

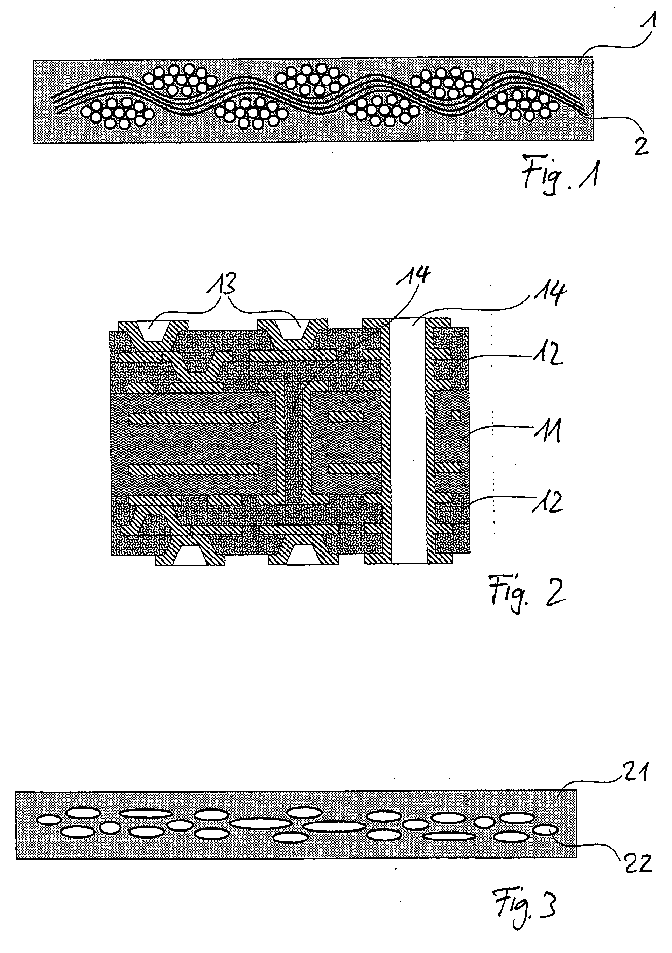

Alle diese Bohrmethoden sind nicht geeignet lange Löcher zu bohren, da dadurch entweder das Risiko eines Bohrerbruches besteht, oder aber das Verfahren zu unwirtschaftlich wird. Zudem sind nicht alle Isolationsstoffe als Basismaterial für Mikrolochanwendungen geeignet, da z.B. Materialien, wie z.B. Epoxidharz die mit Glasfasern verstärkt sind Probleme beim Laserbohren ergeben und eine Mikrolochherstellung durch Plasmaätzen in derartig verstärkten Basismaterialien überhaupt nicht möglich ist. Fig. 1 zeigt einen Querschnitt durch ein solches mit Glasfasern 2 verstärktes Dielektrikum 1.

Ein neues Verfahren zur Herstellung von Mikrolöchern ist in WO 01/50825 beschrieben und verwendet eine Prägematrize zur simultanen Herstellung von kleinsten Mikrolöchern. Dieses Verfahren hat ebenfalls die Beschränkung, dass lediglich relativ kurze Löcher generiert werden können und eine Prägung in ein glasfaserverstärktes Basismaterial nicht möglich ist.

Um solche Basismaterialien für Laser bohrfähig zu machen, sind verschiedene Ansätze bekannt. Einerseits können reine Isolierharze auf eine Kupferfolie auflackiert werden. Diese Folien werden in der Fachwelt als Resin-Coated-Copper-Foil (RCC- Foil) bezeichnet. Sie können nur zum Aufbau weiterer Feinverdrahtungsebenen verwendet werden, wobei der Leiterplattenkern nach wie vor mittels glasfaserverstärkten Materialien aufgebaut wird. Die mechanische Stabilität wird somit durch den stabilen Kern erzeugt, während die ein- oder doppelseitig auflaminierten RCC-Lagen lediglich dazu dienen, Verdrahtungsebenen zu erzeugen, die mittels Laser oder Plasma gebohrt werden können. Die so entstehenden Löcher sind ausschliesslich Sacklöcher.

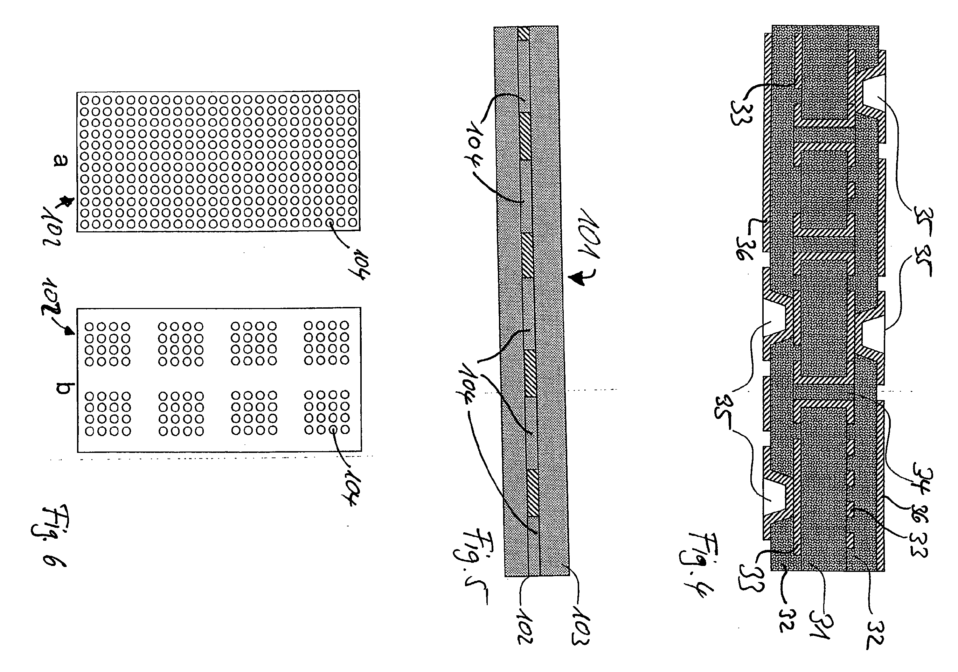

Fig. 2 zeigt einen typischen Aufbau einer HDI-Schaltung mit RCC-Lagen. Im Kern weist sie Harz mit Glasfaserverstärkung 11 auf, darauf sind beidseitig je Lagen aus Harz ohne Glasfaserverstärkung 12 auflaminiert. Die äussersten Kupferlagen des Kerns und die auf Aussenseiten der Lagen ohne Glasfaserverstärkung verlaufenden Kupferleiter sind über plasma- oder Lasergebohrte Mikro-Sacklöcher 13 miteinander verbindbar, während z-Verbindungen durch den Kern hindurch nur über mechanisch gebohrte Löcher 14 möglich sind.

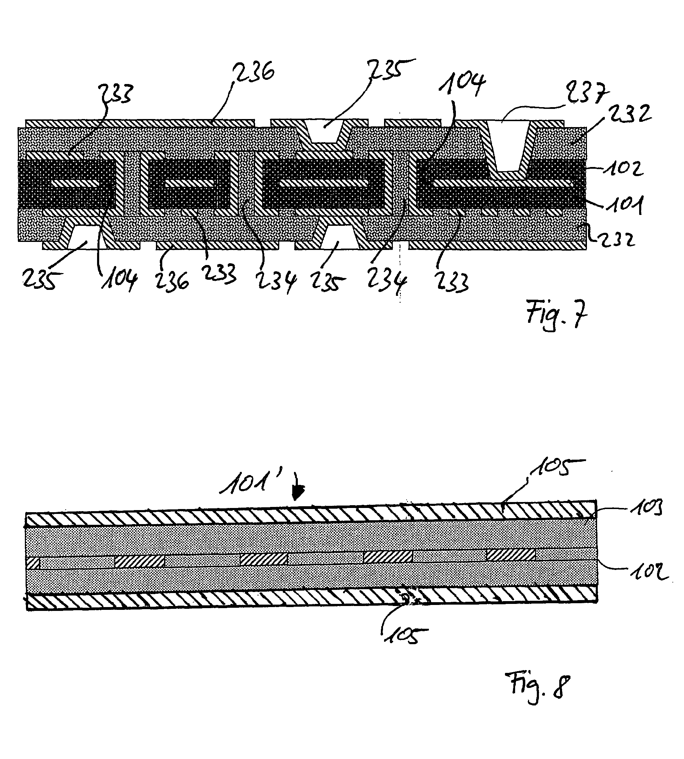

Eine Lösungsmöglichkeit ist der Ersatz der Glasfasergewebe durch ein Gewebe oder Vlies aus einem organischen Material, wie z.B. Aramidfasern, oder Polyphenylene-Sulfide (PPS) -Fasern oder Liquid-Crystal-Polymer (LCP) Fasern. Derartige Faserverbundstoffe sind im Vergleich zu glasfaserverstärkten Materialien grundsätzlich wesentlich besser mittels Laser bohrbar, sie weisen jedoch eine Reihe von anderen Nachteilen auf. Fig. 3 zeigt einen Querschnitt durch ein solches Basismaterial, das aus einem Harz 21 und aus das Harz verstärkenden organischen Fasern 22 besteht.

Bei Aramidfasern ist besonders die hohe Feuchteaufnahme nachteilig, zudem haben die Fasern Wärmeausdehnungskoeffizienten die nicht an das Kupfer angepasst sind. Dadurch entstehen interne Spannungen, die zu Verwölbungen führen können. Alle diese Materialien sind auch mit hohen Kosten verbunden. Ihr Einsatz verbietet sich auch zur Herstellung von sehr dünnen bzw. flexiblen Verdrahtungsträgern da die mit Harz imprägnierten Lagen beim Biegen brechen würden.

Eine Möglichkeit ist der Einsatz von unverstärkten Kunststofffolien, die jedoch nicht nur die hohen Temperaturbelastungen während der Verarbeitung und dem anschliessenden Bestücken und Löten unbeschadet überstehen, sondern auch eine exzellente Dimensionsstabilität aufweisen müssen. Heute sind lediglich zwei Materialien bekannt und auch verfügbar, die diesen Anforderungen genügen: Polyimid- und LCP-Folien.

Ein grundlegend anderes Problem, das mit der Herstellung von hochdichten Leiterplatten bzw. HDI- Schaltungen und Chipcarriern verbunden ist, ist die Tatsache, dass Leiterbahnen aus verdrahtungstechnischen Gründen immer näher zueinander angeordnet werden müssen. Und dies sowohl in x/y als auch in z - Richtung. Bei den zunehmend höheren Schaltfrequenzen ergeben sich dabei Übersprechprobleme (Cross talk), d.h. die einzelnen Leiter müssen entweder möglichst weit voneinander separiert werden - was aus Platzgründen fast nie möglich ist -, oder man verlegt die Leiter auf verschiedene Leiterebenen und schirmt diese durch eine eingeschobene Kupferlage voneinander ab. Bei konventionellen Leiterplatten ist dies relativ einfach zu bewerkstelligen, da nur eine zusätzliche Lage in den Mehrlagenaufbau eingeschoben werden muss. Trotzdem ist dieses Vorgehen mit zusätzlichen Kosten verbunden.

Bei sequentiell aufgebauten HDI-Substraten bzw. Chipträgern verursacht eine zusätzliche Schirmebene gravierende Kostensteigerungen, da eine solche Schirmlage einen zusätzlichen Laminationsschritt und dadurch eine Vervielfachung der Prozessschritte nach sich zieht.

Für flexible und semiflexible HDI-Schaltungen hat sich ein vierlagiger Aufbau gemäss Fig. 4 sehr bewährt. Dabei wird als zentraler Kern 31 ein Folienmaterial aus Polyimid oder LCP, oder auch eine Aramidverstärkte Epoxidharzlage eingesetzt. Der Kern kann zwischen 25 und 150 µm dick sein. Auf seinen Aussenlagen werden üblicherweise alle Signalleiter 33 platziert, die mittels Mikrolöcher 34 auf die Gegenseite geleitet werden können. Der Kern kann mittels traditioneller Methoden der Leiterplattentechnik, wie Laserbohren, Durchkontaktieren und der Anwendung von Photostrukturierverfahren hergestellt werden.

Dieser Kern kann nun zwischen zwei weiteren Lagen 32 einlaminiert werden. Die beiden dadurch neu geschaffenen Aussen-Leiterlagen 36 dienen dabei primär als Stromversorgungslagen aus vollflächig angeordnetem Kupfer, in das die Löt- bzw. Montageflächen eingebettet werden. Durch Mikro-Sacklöcher 35 können die Signale bzw. die Spannungsversorgung und die Erde auf die Aussenlagen geleitet werden.

Obschon der in Fig.4 gezeigte Aufbau praktisch alle Forderungen an hochdichte Schaltungsträger erfüllt, bleibt doch noch das Problem, dass die bei den Signallagen 33 elektrisch nicht voneinander abgeschirmt sind. Da der Kern sehr dünn ist (mikrolochfähig) resultiert daraus die Gefahr untolerierbaren Übersprechens zwischen den zwei Signallagenebenen 33.

Aufgabe der Erfindung ist, ein Basismaterial zur Verfügung zu stellen, welches Nachteile des Standes der Technik vermeidet. Insbesondere sollte es Mikrolochfähig sein und das Herstellen von z-Verbindungen mittels Laser- Plasma und/oder Prägen sowie allenfalls mittels weiterer mechanischer Methoden erlauben. Es sollte eine möglichst gute Dimensions- und je nach Anwendung auch Formstabilität aufweisen.

Erfindungsgemäss ist das Basismaterial eine gelochte elektrisch leitende Folie, die beidseitig mit dielektrischem Material beschichtet, also in dielektrisches Material eingebettet ist. Dabei sind i.A. die in der elektrisch leitenden Folie in regelmässigem Muster angeordneten Löcher mit dem Harz vollständig gefüllt.

"Beidseitig beschichtet" bedeutet hier nicht, dass im Herstellungsverfahren des Basismaterials notwendigerweise die elektrisch leitende Folie mit zwei dielektrischen Schichten versehen werden muss (auf beiden Seiten je eine). Vielmehr ist hier damit gemeint, dass sich auf beiden Seiten der elektrisch leitenden Schicht dielektrisches Material befindet, unabhängig von der Herstellungsart. Dies kann bspw. auch erreicht werden, indem die elektrisch leitende Folie in viskos-flüssiges, auszuhärtendes dielektrisches Material gelegt wird, dass das Dielektrikum aufgespritzt oder gegossen wird, etc.

Ein der Erfindung zu Grunde liegender Gedanke ist derjenige, dass die Anforderungen an ein Basismaterial für elektrische Verbindungselemente so hoch sind und untereinander so stark divergieren, dass ein Material aus einem einzigen Stoff/Stoffgemisch die Anforderungen praktisch nicht mehr erfüllen kann. Daher wird eine heterogene Anordnung von verschiedenen Materialkomponenten vorgeschlagen. Die heterogene Anordnung muss aber trotzdem einfach, kostengünstig und als am Laufmeter produziertes Massenprodukt fertigbar sein; ausserdem sollte die Vielseitigkeit der Einsatzmöglichkeiten im Vergleich zu konventionellen Basismaterialien nicht beeinträchtigt, bzw., was die Bearbeitungsarten angeht, noch erhöht sein.

Es ist überraschend, dass ein verblüffend einfacher Ansatz wie der erfindungsgemässe diesen Anforderungen genügen kann.

Im Allgemeinen ist die Dimensionsstabilität dünner Kunststoffolien eher schlecht. Die Abmessungen der Folie hängen ab von Temperatur, Feuchtigkeit, und anderen externen Parametern, das Verhalten bei Temperaturänderungen kann sogar von der Herstellungsrichtung abhängen. Durch das erfindungsgemässe Vorgehen wird der Nachteil weit gehend behoben. Die elektrisch leitende Folie verleiht dem Basismaterial Stabilität und eine berechenbare, definierte Temperaturabhängigkeit der Abmessungen.

Mit dem erfindungsgemässen Ansatz kann ein Basismaterial geschaffen werden, welches eine Reihe von Vorteilen aufweist:
- Das verstärkende Element ist die elektrisch leitende Folie. Elektrisch leitendes, also im allgemeinen metallisches Material weist einen, im Vergleich zu organischen Verstärkungsmaterialien wie Aramid oder LCP, hohen E-Modul auf und gewährleistet somit eine gute Dimensionsstabilität.
- Die Lage, die durch die elektrisch leitende Folie gebildet wird, kann als Schirmebene genutzt werden, wobei die Löcher das Bohren von Durchsteigern erlaubt, die nicht an die Schirmebene elektrisch angebunden werden sollen.
- Die elektrisch leitende Folie kann als zusätzliche GND bzw. Spannunsversorgungslage genutzt werden.
- Das Basismaterial ist vollständig kompatibel mit bestehenden HDI-Designs. So ist die Verwendung als Kern in einem 4-Lagen HDI-Design wie in Fig. 4 gezeichnet ohne Weiteres möglich.
- Die elektrisch leitende Folie wirkt als ausgezeichneter Wärmeleiter und verbessert das thermische Verhalten der Schaltungen.
- Die elektrisch leitende Folie kann gemäss einer bevorzugten Ausführungsform aus Material mit einem niedrigen Wärmeausdehnungskoeffizienten (α) gefertigt werden, beispielsweise mit einer leitenden Folie aus einer beidseitig kupferbeschichteten Folie aus einer Fe/Ni-Legierung (wie Invar) oder aus rostfreiem Stahl etc. Der Wärmeausdehnungskoeffizient der elektrisch leitenden Folie kann vorzugsweise kleiner als derjenige von Kupfer sein, bspw. sogar kleiner als 12 ppm/K oder 10ppm/K.
- Die Lochstrukturen können durch Stanzen hergestellt oder bereits bei der galvanischen Abscheidung der Folien direkt mitgefertigt werden.
- Der einfache Aufbau und der Einsatz von Standardtechnologien ermöglicht eine kostengünstige Herstellung.
- Das Material weist gegenüber herkömmlichen Basismaterialien eine gleichmässige Dicke und eine kleinere Dickentoleranz auf.
- Durch die erhöhte Dimensionsstabilität und die Berechenbarkeit der Temperaturabhängigkeit wird bei Herstellungsprozessen von elektrischen Verbindungselementen oder anderen Komponenten die Registrierung im Vergleich zu konventionellen Basismaterialien vereinfacht. Dadurch können knappere Toleranzen eingehalten werden, und es ergibt sich eine bessere Ausbeute beim Herstellungsprozess.

Die elektrisch leitende Folie kann aus irgend einem leitenden Material, bspw. Silber, Aluminium, Messing, Stahl, Invar (oder eine andere Fe/Ni-Legierung) oder einer anderen Legierung oder einer Verbundfolie aus einer Kombination der genannten oder anderer Materialien gefertigt sein. Es hat sich gezeigt, dass Kupfer als Folienmaterial besonders vorteilhaft ist:
- Die Wärmeausdehnung einer Kupferfolie beträgt 17 ppm/K. Sie ist mit den anderen Kupferschichten und Basismaterialien kompatibel.
- Das Beschichten von Cu-Folien ist eine Standardtechnologie analog zur Herstellung von RCC -Folien.
- Der relative hohe mechanische E-Modul und die elektrischen Eigenschaften von Kupfer sind speziell vorteilhaft.

Die elektrisch leitende Folie kann eine Dicke von wenigen µm, bspw. 2 µm bis zu 70 µm aufweisen. Normalerweise dürfte eine Dicke von 7-30 µm, bspw. 12-17 µm ein Optimum darstellen. Die gesamte Dicke des Basismaterials kann je nach Anwendung im Bereich von 25 bis 150 µm liegen. Bei HDI-Schaltungen dürfte eine Dicke von 40-100 µm, bspw. 50 -80 µm optimal sein.

Die Löcher können in einem regelmässigen Raster angeordnet sein. Die Abstände zwischen benachbarten Löchern in einem solchen Raster sind bspw. höchstens 2 mm oder höchstens 1 mm und entsprechen mit Vorzug (höchstens) den gängigen Minimalabständen zwischen Mikrolöchern, also bspw. einem Standard-Pitch von 800 µm 500 µm oder 300 µm. Typische Durchmesser für die Löcher sind demnach 50µm bis 150 µm. Das Standardraster kann mit dem übrigen Leitungsmuster rastermässig korrespondieren.

Das Dielektrikum, in welches die leitende Folie eingebettet ist, ist bspw. ein Kunstharz wie ein Epoxidharz oder Poyimid, Cyanatester etc. Das Kunstharz ist bspw. für die Herstellung der Folie versprühbar oder liegt in flüssiger Form vor. Die Folie wird bspw. durch gleichmässiges sprühen des Kunststoffes auf die - bspw. durch Walzen und Stanzen vorgefertigte elektrisch leitende Folie oder durch Eintauchen der elektrisch leitenden Folie in eine Wanne mit dem flüssigen Kuntsstoff gefertigt. Als Alternative zum Stanzen kann die elektrisch leitende Folie auch durch galvanisches Abscheiden oder mit einer anderen Technik hergestellt sein.

In einer Ausführungsform soll das Basismaterial so ausgebildet sein soll, dass es zu einem Substrat zugeschnitten werden kann, welches in an sich aus WO 01/50825 bekannten Herstellungsverfahren als Verbindungselement (Leiterplatten-, HDI- etc.)-Substrat dient. In dieser Ausführungsform ist es vorzugsweise frei von äusseren metallischen Beschichtungen. Es besteht bspw. nur aus der leitenden Folie und dem diese einbettenden (in seiner stofflichen Zusammensetzung homogenen oder heterogenen) Dielektrikum. Es kann aber in anderen Ausführungsformen je nach Verwendung auch bspw. schon mit äusseren Kupferschichten versehen sein, welche im Verbindungselement-Herstellungsverfahren zu Signalleiterlagen strukturiert werden können.

Im Folgenden werden Ausführungsformen der Erfindung anhand von Figuren beschrieben. In den Figuren zeigen:
Fig. 1 bis 4 Materialien und Verbindungselemente gemäss dem Stand der Technik
Fig. 5 einen Querschnitt durch ein erfindungsgemässes Basismaterial.
Fig.6a und 6b je eine Aufsicht auf eine Ausführungsform der Innen liegenden leitenden Folie.
Fig.7 einen vierlagigen HDI-Aufbau mit einem erfindungsgemässen Material, das im Kern der HDI -Schaltung eingesetzt ist. Naturgemäss lassen sich mit diesem Material auch beliebige andere Aufbauten gestalten.
Fig. 8 einen Querschnitt durch eine weitere Ausführungsform des erfindungsgemässen Basismaterials.

Das Basismaterial 101 gemäss **Figur 5** ist ein mit einer gelochten Kupferfolie 102 verstärktes Dielektrikum. In der gezeichneten Anordnung ist die Kupferfolie 102 beidseitig mit je einer Schicht 103 aus Kunstharz, bspw. Epoxydharz versehen. Das Kunstharz fliesst beim Herstellungsprozess des Basismaterials so, dass es auch die Löcher 104 in der Kupferfolie füllt.

**Figur 6** zeigt eine Draufsicht auf zwei Ausführungsformen der Kupferfolie 102 mit Lochmuster. Sowohl die mit a bezeichnete Kupferfolie als auch die mit b bezeichnete Kupferfolie besitzen je regelmässiges Raster von Löchern 104. Im Gegensatz zum Raster a ist das Raster b so ausgebildet, dass sich Zonen mit grosser Lochkonzentration und Zonen ohne Löcher ablösen, hier ebenfalls in einem regelmässigen Muster. Alternativ zur Anordnung gemäss Figur 6 kann auch eine andere Rasterung vorhanden sein, bspw. die dichtestmögliche Anordnung mit paarweise zueinander versetzten Reihen von Löchern oder beliebige andere Raster. Weiter sind auch Anordnungen von Löchern in nicht regelmässigen Rastern möglich, welche bspw. auf bestimmte Anwendungen zugeschnitten sind und bspw. die Mikroloch-Anordnung wiedergeben.

Ein Beispiel für ein erfindungsgemässes elektrisches Verbindungselement ist in der **Figur 7** gezeigt. Das HDI 201 besitzt einen Kern aus erfindungsgemässem Basismaterial 101 mit gelochter Kupferfolie 102, die in ein durch zwei Kunstharzschichten gebildetes Dielektrikum eingebettet ist. Auf seinen Aussenlagen werden bspw. in Analogie zum Aufbau gemäss Fig. 4 Signalleiter 233 platziert, die mittels Mikrolöcher 234 auf die Gegenseite geleitet werden können. Die Mikrolöcher 234 führen dabei durch Löcher 104 in der Kupferfolie, ein elektrischer Kontakt zwischen den Signalleitern und der Kupferfolie wird dadurch vermieden. Die Signalleiter können in konventioneller Weise hergestellt bzw. strukturiert sein. Sie können auch mit dem in WO 01/50825 beschriebenen neuartigen, auf Prägen und galvanischem Auffüllen beruhenden Verfahren gefertigt sein und daher einen im Vergleich zur Figur 7 etwas anderen Querschnitt aufweisen. Die Mikrolöcher können durch Plasma- oder Laserbohren, mechanischem Bohren oder durch Prägen oder eine andere neuartige Methode zum Durchkontaktieren gefertigt sein oder bspw. ebenfalls mit dem in WO 01/50825 beschriebenen Verfahren im selben Verfahrensschritt wie das Herstellen der Leiterstruktur.

Auf den Kern sind zwei weiteren Lagen 232 auflaminiert. Die beiden Aussen-Leiterlagen 236 dienen bspw. ebenfalls primär als Stromversorgungslagen aus vollflächig angeordnetem Kupfer, in das die Löt- bzw. Montageflächen eingebettet werden; alternativ dazu können sie auch als weitere Signalleiterlagen strukturiert sein. Durch Mikro-Sacklöcher 235 können die Signale bzw. die Spannungsversorgung und die Erde auf die Aussenlagen geleitet werden. Es können auch Zentralkonktakt-Mikro-Sacklöcher 237 vorhanden sein, welche die gelochte Cu-Folie mit einer äusseren Schicht elektrisch verbinden und bspw. eine Teilfläche der äusseren Schicht bzw. die Cu-Folie erden oder auf ein anderes definiertes elektrisches Potential bringen. Selbstverständlich können lokal auch Leiterbahnen oder -flächen der Aussenlagen des Kerns mit der gelochten Cu-Folie durch Mikrolöcher elektrisch verbunden sein.

Das Basismaterial 101' gemäss **Figur 8** weist analog zu Figur 5 ein mit einer gelochten Kupferfolie 102 verstärktes Dielektrikum auf. Die Schichten 103 aus Kunstharz, sind je aussenseitig mit einer elektrisch leitenden Schicht 105, bspw. einer Kupferschicht, versehen. Diese kann in einem Strukturierungsverfahren zu einer Leiterstruktur strukturiert werden, welche bspw. Signalleiter wie in Figur 7 aufweist.

Die in Figur 7 gezeichnete Anordnung ist bloss ein Beispiel für die Verwendung des erfindungsgemässen Basismaterials. Das Basismaterial eignet sich für praktisch jede Art von elektrischem Verbindungselement. In mehrlagigen Anordnungen kann es ohne weiteres mehrfach und geschichtet vorkommen.

Speziell geeignet ist das Basismaterial wegen seiner Abschirmeigenschaften auch für Leiterplatten oder HDIs für die Hoch- und Höchstfrequenztechnik oder bspw. für Platinen in Mobiltelefonen etc. Ebenfalls speziell geeignet ist das Basismaterial aufgrund der guten bis (je nach Material der elektrisch leitenden Folie) hervorragenden thermischen Leitfähigkeit für Anwendungen mit hoher Verlustwärme.

## Patentansprüche

1. Basismaterial (101) für elektrische Verbindungselemente, aufweisend eine mit Löchern (104) versehene elektrisch leitende Folie (102), und je eine auf jeder Seite der elektrisch leitenden Folie vorhandene dielektrische Schicht (103).

2. Basismaterial nach Anspruch 1, **dadurch gekennzeichnet, dass** die elektrisch leitende Folie (102) eine Kupferfolie ist.

3. Basismaterial nach Anspruch 1, **dadurch gekennzeichnet, dass** die elektrisch leitende Folie aus einem Material bzw. Materialverbund gefertigt ist, dessen Wärmeausdehnungskoeffizient kleiner ist als derjenige von Kupfer.

4. Basismaterial nach einem der vorangehenden Ansprüche, **dadurch gekennzeichnet, dass** die dielektrischen Schichten Kunstharzschichten (103) sind.

5. Basismaterial nach einem der vorangehenden Ansprüche, **dadurch gekennzeichnet, dass** die Dicke der elektrische leitenden Folie im Bereich 2 µm bis zu 70 µm vorzugsweise 7-30 µm ist.

6. Basismaterial nach einem der vorangehenden Ansprüche, **dadurch gekennzeichnet, dass** die Löcher (104) in einem regelmässigen Raster angeordnet sind.

7. Basismaterial nach Anspruch 6, **dadurch gekennzeichnet, dass** der Abstand der Löcher zu den ihnen benachbarten Löcher (Pitch) zwischen 0.2 mm und 2 mm beträgt.

8. Substrat zum Herstellen eines elektrischen Verbindungselementes, **dadurch gekennzeichnet, dass** es Basimaterial (101) nach einem der Ansprüche 1 bis 7 aufweist.

9. Elektrisches Verbindungselement, **dadurch gekennzeichnet, dass** es eine Lage aus dem Basismaterial (101) nach einem der Ansprüche 1 bis 7 aufweist.
